(19) Europäisches Patentamt
European Patent Office
Office européen des brevets

(11) **EP 2 866 315 A2**

(12) **EUROPÄISCHE PATENTANMELDUNG**

(43) Veröffentlichungstag:
**29.04.2015   Patentblatt 2015/18**

(51) Int Cl.:
*H01S 5/12* (2006.01)       *H01S 5/22* (2006.01)
*H01S 5/32* (2006.01)

(21) Anmeldenummer: **14185737.5**

(22) Anmeldetag: **22.09.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **25.10.2013   DE 102013111770**

(71) Anmelder: **nanoplus Nanosystems and Technologies GmbH
97218 Gerbrunn (DE)**

(72) Erfinder:
• **Koeth, Johannes
97218 Gerbrunn (DE)**
• **Zimmermann, Christian
63906 Erlenbach (DE)**
• **Scheuermann, Julian
97204 Höchberg (DE)**

(74) Vertreter: **advotec.
Patent- und Rechtsanwälte
Beethovenstrasse 5
97080 Würzburg (DE)**

(54)    **Halbleiterlaserdiode mit einstellbarer Emissionswellenlänge**

(57)    Die Erfindung betrifft eine Halbleiterlaserdiode (01) aufweisend eine Substratschicht, eine erste dotierte und eine zweite dotierte Mantelschicht (02,09), zumindest einen Wellenleiter (03, 04), eine aktive Schicht, eine an die aktive Schicht oder den zumindest einen Wellenleiter (03, 04) angrenzende Mantelschichtstruktur (05) und zumindest einen Interdigitaltransducer (08), wobei der zumindest eine Interdigitaltransducer (08) an die Mantelschichtstruktur (05) angrenzt und die Mantelschichtstruktur (05) zumindest einen ersten Bereich (06) aufweist, der als im Wesentlichen undotierte Halbleiterschicht ausgeführt ist und zumindest abschnittsweise einen zweiten Bereich (07) aufweist, der auf einer Seite an den ersten Bereich (06) und auf einer anderen Seite an den Interdigitaltransducer (08) angrenzt, wobei der zweite Bereich (07) eine gegenüber dem ersten Bereich (06) verringerte Dichte freier Ladungsträger aufweist.

Fig. 1

EP 2 866 315 A2

**Beschreibung**

Die vorliegende Erfindung betrifft eine Halbleiterlaserdiode mit einstellbarer Emissionswellenlänge samt des epitaktischen und/oder lithographischen Aufbaus der Halbleiterlaserdiode.

Halbleiterlaser besitzen aufgrund ihrer endlichen Verstärkungsbandbreite ein Modenspektrum, welches eine Vielzahl so genannter Fabry-Perot-Moden enthält. Der spektrale Abstand der einzelnen Moden ist über

$$\Delta\lambda = \frac{\lambda^2}{2 n_g L}$$

definiert, wobei $\lambda$ die Wellenlänge, $n_g$ der Gruppenindex und L die Kavitätslänge der Halbleiterlaserdiode ist. Für eine Vielzahl von Anwendungen, wie beispielsweise die Spektroskopie, die Telekommunikation oder die Meteorologie, ist es besonders wünschenswert, einzelne, wohl definierte Fabry-Perot-Moden des gesamten Modenspektrums als Emissionswellenlänge einer Halbleiterlaserdiode zu selektieren und die Halbleiterlaserdiode in genau dieser bzw. mit genau dieser Mode bzw. Wellenlänge zu betreiben. Dabei sind verschiedene Verfahren zur Herstellung bzw. Strukturen von Halbleiterlaserdioden bekannt, die eine Selektion der Emissionswellenlänge erlauben.

So ist es beispielsweise für oberflächenemittierende Laserdioden, so genannte "vertical cavity surface emitting laser" (VCSEL), durch die Wahl einer entsprechend kurzen Kavitätslänge, beispielsweise das 1-3-fache der Wellenlänge, möglich, den Abstand zweier benachbarter Fabry-Perot-Moden in derartigen Bauteilen derart groß ausfallen zu lassen, dass deren Abstand die Verstärkungsbandbreite überschreitet und nur eine Mode innerhalb der Verstärkungsbandbreite zum Laserbetrieb beiträgt.

Im Gegensatz dazu weisen kantenemittierende Laser, deren Kavitätslänge meist mehrere 100 $\mu$m bis einige mm beträgt, jedoch tausende Fabry-Perot-Moden im Bereich der jeweiligen Verstärkungsbandbreite auf. Um bei diesen Bauelementen eine Einschränkung der Moden der Emissionswellenlänge bzw. eine größere spektrale Reinheit zu ermöglichen, sind ebenfalls verschiedene Verfahren zur Herstellung bzw. daraus resultierende Strukturen der entsprechenden Halbleiterlaserdioden bekannt. Beispielsweise können Rückkopplungsmechanismen verwendet werden, welche entweder monolithisch in die Halbleiterlaserdiode eingearbeitet oder auch extern in einen Strahlengang der Halbleiterlaserdioden eingebracht werden können.

Im Rahmen monolithischer Strukturen von Halbleiterlaserdioden zur Modenselektion ist beispielsweise das so genannte "distributed feedback" (DFB) Prinzip bekannt, welches auf einer periodischen Modulation des Brechungsindexes und/oder der Verstärkung in dem gepumpten Bereich der Halbleiterlaserdiode beruht. Alternativ dazu sind so genannte "distributed bragg reflector-Laserdioden" (DBR-Laser) bekannt, welche eine periodische Brechungsindexmodulation in einem passiven Bereich der Halbleiterlaserdiode aufweisen.

Bei der externen Modenselektion von Halbleiterlaserdioden können Gitter zum Einsatz kommen, wobei der Laserchip als Verstärker eingesetzt wird und das Gitter als eine zweite Facette dient. Der letztgenannte Aufbau von Halbleiterlaserdioden wird auch "external cavity diode laser" (ECDL) genannt.

Die vorangehend beschriebenen Verfahren und Vorrichtungen zur Modenselektion einer Halbleiterlaserdiode weisen dabei den Nachteil auf, dass entweder nur äußerst begrenzte Bereiche des gesamten Modenspektrums selektiert werden können bzw. dass das Vorsehen mechanischer Komponenten sich besonders nachteilig auf Preis und Systemgröße der entsprechenden Laser auswirkt.

Zudem existieren weitere Halbleiterlaserdioden, beispielsweise Halbleiterlaserdioden mit einem so genannten "binary superimposed grating" (BSG), welche zwar einen weiten Bereich des Modenspektrums wohl definiert selektieren können, jedoch in der Produktion und Charakterisierung der Laserdioden sehr kosten- und zeitintensiv sind.

Eine kostengünstige und sehr leistungsfähige Alternative zur selektiven Auswahl einer bestimmten Emissionswellenlänge aus dem Modenspektrum einer Halbleiterlaserdiode bietet dabei das Vorsehen eines so genannten "integrierten Interdigitaltransducers" (IDTs), welcher eine akustische Oberflächenwelle oder "surface acoustic wave" (SAW) anregt, die wiederum zu einer periodischen Modulation des Brechungsindexes in einer an den Interdigitaltransducer angrenzenden Schicht führt und somit ähnlich wie bei den vorangehend beschriebenen Möglichkeiten eine selektive Modenwahl der Emissionswellenlänge ermöglicht.

Dabei weisen die bekannten Interdigitaltransducer, je nach ihrer Ausführung, ein entsprechend schmales oder breites Resonanzverhalten auf, wobei die jeweiligen Resonanzzustände durch ein extern angelegtes Signal bzw. eine Wechselspannung in einem entsprechend schmalen Frequenzbereich angeregt werden können. Um in einem entsprechenden Laser bzw. einer entsprechenden Halbleiterlaserdiode eine möglichst weitreichende Selektion der Emissionswellenlänge vornehmen zu können, kann dementsprechend vorgesehen sein, dass ein Interdigitaltransducer an sich derart ausgestaltet ist, dass er ein breites Resonanzband aufweist, und der Interdigitaltransducer von außen mit einem möglichst schmalen Frequenzband bzw. einer möglichst eindeutigen Frequenz angeregt wird. Eine derartige Halbleiterlaserdiode wird beispielsweise in der WO 2012/074382 A1 beschrieben.

Nachteilig an den bekannten Halbleiterlaserdioden mit selektierbarer bzw. einstellbarer Emissionswellenlänge unter Verwendung eines Interdigitaltransducers ist dabei, dass die Erzeugung bzw. die Ausbreitung oder Aufrechterhaltung der akustischen Oberflächenwelle in dem an den Interdigitaltransducer angrenzenden Bereich bzw. in der an den Interdigitaltransducer angrenzenden Schicht der Halbleiterlaserdiode nur schlecht bzw. nur zu einem geringen Ausmaß gelingt, wodurch die beabsichtigte oder gewünschte Modulation des Brechungsindexes in diesem Bereich bzw. in dieser Schicht ebenfalls nur schlecht oder nur zu einem geringen Ausmaß und damit insgesamt unzureichend erfolgt, und dadurch schließlich auch die Einstellung bzw. die Selektion einer Emissionswellenlänge aus dem Modenspektrum der Halbleiterlaserdiode nur zu einem gewissen Grad ermöglicht wird oder aufrechterhalten werden kann.

Dementsprechend ist es die Aufgabe der vorliegenden Erfindung, eine Halbleiterlaserdiode mit selektierbarer bzw. einstellbarer Emissionswellenlänge vorzuschlagen, welche die vorangehend beschriebenen Nachteile im Stand der Technik überwindet. Dies bedeutet auch, dass die Emissionswellenlänge dynamisch, während des Betriebs der Laserdiode einstellbar und nach der Einstellung, soweit gewünscht, konstant ist. Mit anderen Worten ausgedrückt bedeutet dies, dass es das Anliegen der vorliegenden Erfindung ist, eine gattungsgemäße Halbleiterlaserdiode derart weiterzuentwickeln, dass eine effektive und stabile Erzeugung und Aufrechterhaltung einer akustischen Oberflächenwelle mittels eines Interdigitaltransducers ermöglicht wird.

Diese Aufgabe wird durch eine Halbleiterlaserdiode gemäß dem Oberbegriff des Anspruchs 1 gelöst. Vorteilhafte Weiterbildungen der vorgeschlagenen Halbleiterlaserdiode sind Gegenstand der Unteransprüche. Die vorliegende Erfindung basiert auf der Grundidee, dass eine akustische Oberflächenwelle mittels eines Interdigitaltransducers in einer an den Interdigitaltransducer angrenzenden Schicht dann besonders gut oder effektiv erzeugt und aufrechterhalten werden kann, wenn die an den Interdigitaltransducer angrenzende Schicht bzw. der an den Interdigitaltransducer angrenzende Bereich besonders gute piezoelektrische Eigenschaften aufweist. Da besonders gute piezoelektrische Eigenschaften durch eine möglichst geringe oder sogar nicht vorhandene Dichte an freien Ladungsträgern erreicht werden, besteht mit anderen Worten ausgedrückt, die Grundidee der vorliegenden Erfindung auch darin, die Halbleiterlaserdiode derart auszugestalten, dass eine an einen Interdigitaltransducer angrenzende Schicht oder ein Bereich einer derartigen Schicht vorgesehen ist, die bzw. der lediglich ein Mindestmaß an freien Ladungsträgern aufweist.

Dementsprechend ist vorgesehen, dass die erfindungsgemäße Halbleiterlaserdiode eine Substratschicht, eine erste dotierte und eine zweite dotierte Mantelschicht, zumindest einen Wellenleiter, eine aktive Schicht, eine an die aktive Schicht oder den zumindest einen Wellenleiter angrenzende Mantelschichtstruktur und zumindest einen Interdigitaltransducer aufweist, wobei der zumindest eine Interdigitaltransducer an die Mantelschichtstruktur angrenzt und die Mantelschichtstruktur zumindest einen ersten Bereich aufweist, der als im Wesentlichen undotierte Halbleiterschicht ausgeführt ist und bezogen auf den ersten Bereich zumindest abschnittsweise einen zweiten Bereich aufweist, der auf einer Seite an den ersten Bereich und auf einer anderen Seite an den Interdigitaltransducer angrenzt, wobei der zweite Bereich eine gegenüber dem ersten Bereich verringerte Dichte freier Ladungsträger aufweist.

Dabei sei hervorgehoben, dass im Rahmen der vorliegenden Erfindung als im Wesentlichen undotierte Halbleiterschichten diejenigen Halbleiterschichten zu verstehen sind, die an sich aufgrund des gewählten Materials und des gewollten Herstellungs- bzw. Abscheideprozesses keinerlei Ladungsträger aufweisen sollten, jedoch aufgrund verschiedener Phänomene, wie beispielsweise Verunreinigungen, Fehlstellen oder Gitterdefekte, trotzdem immer ein gewisses Maß an freien Ladungsträgern aufweisen, selbst wenn solche Halbleiterschichten allgemein bereits als intrinsische Halbleiterschichten bezeichnet werden.

Mit anderen Worten ausgedrückt bedeutet dies, dass gemäß der erfindungsgemäßen Halbleiterlaserdiode ein erster Bereich der Mantelschichtstruktur vorgesehen ist, der im Allgemeinen bereits als intrinsische Halbleiterschicht bezeichnet werden kann, und gleichzeitig der zweite Bereich, der zumindest abschnittsweise zwischen dem ersten Bereich der Mantelschichtstruktur und dem Interdigitaltransducer angeordnet ist, eine nochmals deutlich gegenüber dem ersten Bereich verringerte Dichte freier Ladungsträger aufweist.

Durch die erfindungsgemäße Halbleiterlaserdiode wird ermöglicht, dass die Eigenschaften der akustischen Oberflächenwelle, die gemäß der entsprechenden Anregungsfrequenz vom Interdigitaltransducer erzeugt wird, besonders effektiv und wohl definiert erzeugt und aufrechterhalten werden können, wodurch im Endeffekt eine ebenfalls sehr effektive und wohl definierte Einstellung oder Selektion einer einzelnen Emissionswellenlänge aus dem Modenspektrum der Halbleiterlaserdiode erfolgen kann.

Dabei könnte im Rahmen der Erfindung vorgesehen sein, dass der zweite Bereich der Mantelschichtstruktur aus einer aluminiumhaltigen Schicht, insbesondere aus einer Aluminiumnitridschicht, besteht. Vorteilhaft an der Verwendung eines aluminiumhaltigen Materials für den zweiten Bereich der Mantelschichtstruktur und insbesondere bei der Verwendung von einer Aluminiumnitridschicht ist dabei, dass derartige Halbleiterschichten im Gegensatz zu anderen intrinsischen Halbleiterschichten oder Verbindungshalbleiterschichten deutlich bessere piezoelektrische Eigenschaften aufweisen. Mit anderen Worten ausgedrückt bedeutet dies, dass die vorgeschlagenen vorteilhaften Schichten auch eine deutlich geringere Dichte von freien Ladungsträgern gegenüber anderen intrinsischen Halbleiterschichten oder Verbindungshalbleiterschichten aufweisen.

Allgemein sind für den zweiten Bereich der Mantelschichtstruktur Materialien wünschenswert, die eine besonders hohe Polarisation bei mechanischer Verformung bzw. eine besonders starke piezoelektrische Eigenschaft aufweisen, da sich in diesen Materialien die akustische Oberflächenwelle des Interdigitaltransducers besonders effektiv erzeugen und aufrechterhalten lässt. Es kann demnach bevorzugt sein, dass der zweite Bereich der Mantelschichtstruktur aus Zinkoxid (ZnO) besteht.

Derartige Schichten können bei der Herstellung einer entsprechenden Halbleiterlaserdiode ohne weitere Schwierigkeiten in den Prozessfluss integriert und auf an sich bekannte Weise erzeugt bzw. abgeschieden werden. Ein weiterer Vorteil der aluminiumhaltigen Schichten bzw. der Aluminiumnitridschicht im zweiten Bereich der Mantelschichtstruktur der vorgeschlagenen Halbleiterlaserdiode besteht darin, dass sich deren vorteilhafte piezoelektrische Eigenschaften und die dadurch erzeugte vorteilhafte Wirkung auf die akustische Oberflächenwelle und die von dieser Oberflächenwelle abhängige Modenselektion der Halbleiterlaserdiode unabhängig von der sonstigen Wahl des Lasersystems bzw. der Materialwahl des Lasersystems realisieren lassen. Dementsprechend sind die vorteilhaften Wirkungen systemunabhängig und lassen sich demnach bei einer Fülle von unterschiedlichen Halbleiterlaserdioden mit unterschiedlichsten Ausgangsleistungen oder sonstigen Charakteristika realisieren.

Im Rahmen der vorgeschlagenen Erfindung könnte ebenfalls vorgesehen sein, dass der zweite Bereich aus einem Halbleitermaterial, insbesondere aus einem III-V-Halbleitermaterial, besteht und eine Konterdotierung aufweist. Derartige Konterdotierungen sind für die jeweiligen Halbleitermaterialien oder Verbindungshalbleitermaterialien hinlänglich bekannt und können im Rahmen des Verfahrens zur Herstellung des zweiten Bereichs der Mantelschichtstruktur ohne Weiteres zusammen mit dem eigentlichen Halbleiter- bzw. Verbindungshalbleitermaterial erzeugt bzw. abgeschieden werden.

Dazu können beispielsweise Verfahren, wie die Molekularstrahlepitaxie oder die metallorganische Gasphasenepitaxie, verwendet werden. Ein Beispiel für eine derartige Mantelschichtstruktur ist beispielsweise eine AlGaAsSb-Schicht im ersten Bereich der Mantelschichtstruktur, welche eine intrinsische p-Dotierung aufweist, und eine entsprechende Al-GaAsSb-Schicht im zweiten Bereich der Mantelschichtstruktur, welche mit Tellur (Te) oder Silizium (Si) konterdotiert ist, um die piezoelektrischen Eigenschaften zu verbessern bzw. die Dichte freier Ladungsträger gegenüber dem bereits an sich intrinsischen ersten Bereich der Mantelschichtstruktur weiter zu verringern. Eine derartige Mantelschichtstruktur kann beispielsweise in einem GaSb-Halbleiterlaserdiodensystem zum Einsatz kommen, welches mittels Molekularstrahlepitaxie erzeugt wird.

Dabei ist es besonders wünschenswert, dass der erste Bereich der Mantelschichtstruktur einen Großteil bzw. den größten Teil der Mantelschichtstruktur ausmacht und der zweite Bereich bzw. der Bereich, der die Konterdotierung aufweist, nur eine geringe Tiefe oder Stärke der Mantelschichtstruktur ausmacht. Im Extremfall ist der zweite Bereich lediglich als Grenzfläche zwischen dem ersten Bereich der Mantelschichtstruktur und dem angrenzenden Interdigitaltransducer ausgestaltet, die lediglich so stark bzw. so tief ist, dass die akustische Oberflächenwelle erzeugt und aufrechterhalten bzw. geführt werden kann. Denn durch die Konterdotierung im zweiten Bereich der Mantelschichtstruktur wird zwar einerseits die Erzeugung und Aufrechterhaltung der akustischen Oberflächenwelle positiv beeinflusst, jedoch gleichzeitig in nachteiliger Weise der elektrische Widerstand erhöht.

Ebenfalls könnte im Rahmen der vorgeschlagenen Erfindung vorgesehen sein, dass der zweite Bereich aus einem Halbleitermaterial, insbesondere aus einem III-V-Halbleitermaterial, besteht und Wasserstoffatome aufweist. Dabei sind die Wasserstoffatome gezielt eingebracht und bilden mit den vorhandenen Halbleitermaterialien Verbindungen bzw. Komplexe über starke oder schwache kovalente Bindungen.

Das gezielte Einbringen der Wasserstoffatome kann beispielsweise über eine Behandlung der Mantelschichtstruktur mit einem Wasserstoffplasma bzw. mit einer anderen Behandlung mit Wasserstoffradikalen erfolgen. In an sich bekannter Weise kann oberhalb einer Schwellentemperatur des Substrats bzw. der Mantelschichtstruktur ein Eintrag von Wasserstoffradikalen in den zweiten Bereich der Mantelschichtstruktur erfolgen, welche dann zur Passivierung von freien Ladungsträgern durch Neutralisierung oder Komplexbildung der Dotieratome zu entsprechenden Wasserstoffatomen reagieren. Dabei kann die Eindringtiefe der Wasserstoffradikale und damit auch das Verhältnis des ersten Bereichs der Mantelschichtstruktur zum zweiten Bereich der Mantelschichtstruktur über die Dauer der Einwirkung der Wasserstoffradikale und die damit korrelierte Eindringtiefe der Wasserstoffradikale bestimmt werden.

Für die vorgeschlagene Halbleiterlaserdiode könnte im Rahmen der vorliegenden Erfindung auch vorgesehen sein, dass der erste Bereich der Mantelschichtstruktur aus einem Halbleitermaterial, insbesondere aus einem III-V-Halbleitermaterial, besteht. Derartige Materialien sind für die Erzeugung von entsprechenden Halbleiterlaserdioden weitverbreitet, und deren Handhabung ist wohl bekannt und gut dokumentiert.

Die vorgeschlagene Halbleiterlaserdiode könnte auch dadurch vorteilhaft weitergebildet werden, dass die aktive Schicht Quantenpunkte aufweist. Die bisherigen Halbleiterlaserdioden, welche eine Modenselektion bzw. eine Einstellung der Emissionswellenlänge mittels eines Interdigitaltransducers vorsehen, sind derart ausgestaltet, dass die aktive Schicht einen Quantenfilm aufweist. Die vorgeschlagenen Quantenpunkte haben demgegenüber jedoch den Vorteil, dass diese eine aktive Schicht ermöglichen, welche eine Amplitudenmodulation der Emissionswellenlänge gestattet. Diese Amplitudenmodulation ist insbesondere bei der Signalübertragung eine wichtige Größe. Dementsprechend könnte die vorgeschlagene Halbleiterlaserdiode gleichzeitig eine Modulation der Emissionswellenlänge bzw. eine Modenselektion aus dem Modenspektrum und eine Amplitudenmodulation ermöglichen, was insgesamt zu einer sehr vorteilhaften und damit wünschenswerten Charakteristik oder möglichen Charakteristiken der Halbleiterlaserdiode führt.

Im Rahmen der vorliegenden Erfindung könnte es zudem vorteilhaft sein, wenn die aktive Schicht Quantendashs aufweist. Auch dadurch wird eine Amplitudenmodulation in der aktiven Schicht ermöglicht, was die vorangehend bereits beschriebenen Vorteile einer derartigen Halbleiterlaserdiode mit sich bringt.

Ebenfalls könnten weitere Vorteile der vorliegenden Erfindung dadurch erzielt werden, dass die aktive Schicht Halbleitermaterialien bzw. aus diesen Halbleitermaterialien gebildete Schichten mit lediglich einer Art von Dotierung aufweist. Derartige Halbleiterlaserdioden mit lediglich einer Dotierungsart in der aktiven Schicht können beispielsweise als Interbandkaskadenlaser oder Quantenkaskadenlaser ausgebildet sein, die ihrerseits besondere Vorteile aufweisen und die in zusätzlicher besonders vorteilhafter Weise mit den vorangehend beschriebenen Vorteilen der Erfindung, wie insbesondere der verbesserten Einstellbarkeit der Emissionswellenlänge bzw. Modenselektion, und der dadurch erreichten Definition der Emissionswellenlänge kombiniert werden können. Beispielsweise, jedoch keineswegs ausschließlich, können aktive Schichten mit Halbleitermaterialien bzw. Schichten mit lediglich einer Art von Dotierung unterschiedliche n-Dotierungen bzw. Halbleitermaterialien mit unterschiedlichen n-Dotierungen aufweisen.

Es könnte auch vorteilhaft für die vorgeschlagene Halbleiterlaserdiode sein, wenn der zumindest eine Interdigitaltransducer als kammartige Struktur ausgebildet ist. So lassen sich in besonders einfacher und vorteilhafter Weise entsprechende Resonanzcharakteristiken bzw. ein entsprechendes Resonanzverhalten der Interdigitaltransducer vorhersehen und realisieren.

Auch könnte es für die vorgeschlagene Halbleiterlaserdiode besonders vorteilhaft sein, wenn der zumindest eine Interdigitaltransducer ein leitfähiges Material, insbesondere Gold, aufweist. Dadurch kann eine besonders effektive Erzeugung und Aufrechterhaltung der akustischen Oberflächenwelle ermöglicht werden.

Die vorliegende Erfindung wird nachfolgend anhand einer lediglich schematischen Zeichnung beispielhaft erläutert.

Es zeigt:

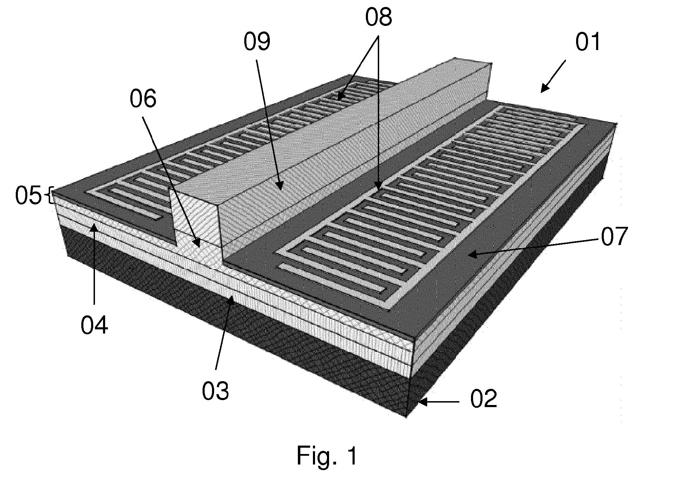

Fig. 1 einen perspektivische Ansicht einer erfindungsgemäßen Halbleiterlaserdiode in einem ersten Ausführungsbeispiel.

Fig. 1 zeigt eine Halbleiterlaserdiode 01, die eine n-Mantelschicht 02 auf einem nicht dargestellten Substrat aufweist. Als n-Mantelschicht soll dabei eine n-dotierte Mantelschicht verstanden werden. Oberhalb der n-Mantelschicht 02 ist eine aktive Schicht angedeutet, die als Grenzfläche bzw. als Grenzlinie zwischen den Wellenleitern 03 und 04 angeordnet ist. Auf der Oberseite des Wellenleiters 04 ist wiederum die Mantelschichtstruktur 05 aufgebracht. Die Mantelschichtstruktur 05 weist dabei einen ersten Bereich 06 sowie zumindest abschnittsweise einen zweiten Bereich 07 auf. Oberhalb der Mantelschichtstruktur 05 befinden sich zwei Interdigitaltransducer 08, jeweils über dem Bereich der Mantelschichtstruktur, der sowohl einen ersten als auch einen zweiten Bereich aufweist. Zwischen den Interdigitaltransducern 08 weist die Mantelschichtstruktur 05 lediglich einen ersten Bereich 06 auf, der an eine p-Mantelschicht 09 angrenzt. Im Sinne dieser Beschreibung ist eine p-Mantelschicht als p-dotierte Mantelschicht der Halbleiterlaserdiode zu verstehen.

Im Beispiel der Fig. 1 kann der zweite Bereich 07 der Mantelschichtstruktur 05 beispielsweise aus Aluminiumnitrid gebildet sein, wodurch die mittels der Interdigitaltransducer 08 erzeugte akustische Oberflächenwelle besonders wohl definiert angeregt und aufrechterhalten werden kann. Dadurch wird wiederum eine Modulation des Brechungsindexes in der Mantelschichtstruktur 05 erreicht, die eine gleichermaßen wohl definierte Einstellung bzw. Selektion einer Mode des Modenspektrums der von der Verstärkungsbandbreite der Halbleiterlaserdiode 01 umfassten Farby-Perot-Moden und eine dementsprechende selektive Wahl einer Emissionswellenlänge der Halbleiterlaserdiode 01 ermöglicht.

Die in Fig. 1 dargestellte Abfolge der Schichtstruktur ist dabei jedoch keinesfalls bindend. Beispielsweise kann auch vorgesehen sein, dass der zumindest eine Interdigitaltransducer zwischen der n-Mantelschicht 02 und einer Mantelschichtstruktur angeordnet ist, an die oberhalb die aktive Schicht und der Wellenleiter angrenzen.

## Patentansprüche

1. Halbleiterlaserdiode (01) aufweisend eine Substratschicht, eine erste dotierte und eine zweite dotierte Mantelschicht (02,09), zumindest einen Wellenleiter (03, 04), eine aktive Schicht, eine an die aktive Schicht oder den zumindest einen Wellenleiter (03, 04) angrenzende Mantelschichtstruktur (05) und zumindest einen Interdigitaltransducer (08),

   **dadurch gekennzeichnet,**

   **dass** der zumindest eine Interdigitaltransducer (08) an die Mantelschichtstruktur (05) angrenzt und die Mantelschichtstruktur (05) zumindest einen ersten Bereich (06) aufweist, der als im Wesentlichen undotierte Halbleiterschicht ausgeführt ist und zumindest abschnittsweise einen zweiten Bereich (07) aufweist, der auf einer Seite an den ersten Bereich (06) und auf einer anderen Seite an den Interdigitaltransducer (08) angrenzt, wobei der zweite Bereich (07) eine gegenüber dem ersten Bereich (06) verringerte Dichte freier Ladungsträger aufweist.

2. Halbleiterlaserdiode (01) nach Anspruch 1,
   **dadurch gekennzeichnet,**
   **dass** der zweite Bereich (07) aus einer aluminiumhaltigen Schicht, insbesondere aus einer Aluminiumnitrid-Schicht (AlN-Schicht), besteht.

3. Halbleiterlaserdiode (01) nach Anspruch 1,
   **dadurch gekennzeichnet,**
   **dass** der zweite Bereich (07) aus Zinkoxid (ZnO) besteht.

4. Halbleiterlaserdiode (01) nach Anspruch 1,
   **dadurch gekennzeichnet,**
   **dass** der zweite Bereich (07) aus einem Halbleitermaterial, insbesondere aus einem III-V-Halbleitermaterial, besteht und eine Konterdotierung aufweist.

5. Halbleiterlaserdiode (01) nach Anspruch 1,
   **dadurch gekennzeichnet,**
   **dass** der zweite Bereich (07) aus einem Halbleitermaterial, insbesondere aus einem III-V-Halbleitermaterial, besteht und Wasserstoffatome aufweist.

6. Halbleiterlaserdiode (01) nach einem der Ansprüche 1 bis 5,
   **dadurch gekennzeichnet,**
   **dass** der erste Bereich (06) aus einem Halbleitermaterial, insbesondere aus einem III-V-Halbleitermaterial, besteht.

7. Halbleiterlaserdiode (01) nach einem der Ansprüche 1 bis 6,
   **dadurch gekennzeichnet,**
   **dass** die aktive Schicht Quantenpunkte aufweist.

8. Halbleiterlaserdiode (01) nach einem der Ansprüche 1 bis 6,
   **dadurch gekennzeichnet,**
   **dass** die aktive Schicht Quantendashs aufweist.

9. Halbleiterlaserdiode (01) nach einem der Ansprüche 1 bis 8,
   **dadurch gekennzeichnet,**
   **dass** die aktive Schicht Halbleitermaterialien mit lediglich einer Art von Dotierung aufweist.

10. Halbleiterlaserdiode (01) nach einem der Ansprüche 1 bis 9,
    **dadurch gekennzeichnet,**
    **dass** der zumindest eine Interdigitaltransducer (08) als kammartige Struktur ausgebildet ist.

11. Halbleiterlaserdiode (01) nach einem der Ansprüche 1 bis 10,
    **dadurch gekennzeichnet,**
    **dass** der zumindest eine Interdigitaltransducer (08) ein leitfähiges Material, insbesondere Gold, aufweist.

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2012074382 A1